# EUROPÄISCHE PATENTSCHRIFT

(11) **EP 3 449 032 B1**
(45) Veröffentlichungstag und Bekanntmachung des Hinweises auf die Patenterteilung: **11.03.2020**
(21) Anmeldenummer: 17721115.8
(22) Anmeldetag: 28.04.2017
(51) Int. Cl.: C23C 28/00, C23C 14/06, C23C 14/32, F16J 9/26, C23C 14/02

(54) **GLEITELEMENT, INSBESONDERE KOLBENRING**
SLIDING ELEMENT, IN PARTICULAR PISTON RING
ÉLÉMENT COULISSANT, NOTAMMENT SEGMENT DE PISTON

(30) Priorität: 28.04.2016 DE 102016107874
(43) Veröffentlichungstag der Anmeldung: 06.03.2019
(73) Patentinhaber: Federal-Mogul Burscheid GmbH, 51399 Burscheid (DE)
(72) Erfinder: KENNEDY, Marcus, 40477 Düsseldorf (DE); IVANOV, Yuriy, 51339 Burscheid (DE)
(74) Vertreter: Hoffmann Eitle
(86) Internationale Anmeldenummer: PCT/EP2017/060200
(87) Internationale Veröffentlichungsnummer: WO 2017/186915

(56) Entgegenhaltungen:
- CN-A- 1 827 845
- JP-A- 2004 137 541
- US-A1- 2015 267 746
- VOEVODIN A A ET AL: "Design of a Ti/TiC/DLC functionally gradient coating based on studies of structural transitions in Ti-C thin films", THIN SOLID FILMS, ELSEVIER, AMSTERDAM, NL, Bd. 298, Nr. 1-2, 20. April 1997 (1997-04-20), Seiten 107-115, XP004125924, ISSN: 0040-6090, DOI: 10.1016/S0040-6090(96)09145-6

## Beschreibung

### Technisches Gebiet

Die Erfindung betrifft ein Gleitelement, insbesondere einen Kolbenring, mit einer Beschichtung.

### Stand der Technik

Für Kolbenringe, die Temperaturen von teilweise mehr als 300°C ausgesetzt sind und möglichst dauerhaft einen möglichst geringen Reibkoeffizienten aufzuweisen haben, ist es bekannt, Schichtsysteme vorzusehen, die eine Haftschicht, eine oder mehrere DLC-Schichten sowie gegebenenfalls Zwischenschichten aufweisen.

Einen alternativen Ansatz lehrt die DE 10 2008 042 896 A1, die ein Verfahren zur Beschichtung eines Gleitelements, insbesondere eines Kolbenringes oder einer Zylinderlaufbuchse eines Verbrennungsmotors, bei dem während der Abscheidung einer Hartstoffschicht DLC-Phasen in die Hartstoffschicht eingelagert werden, offenbart.

A. Voevodin beschreibt eine Beschichtung aus Ti/TiC/DLC (A.A. Voevodin et al., Thin Solid Films 298 (1997) 107-115). Patentdokument US2011/0101620A1 offenabrt eine DLC Beschichtung für einen Kolbenring.

Eine Übersicht von unterschiedlichen DLC Schichttypen und deren Eigenschaften ist in der VDI Richtlinie 2840 zu finden. Hier sind z.B. die folgenden Werte für die maximale thermische Stabilität angegeben:

| Schichttyp | Maximale thermische Stabilität |
|---|---|
| a-C | 450 °C |
| ta-C | 500 °C |
| a-C:H | 400 °C |
| ta-C:H | 500 °C |
| a-C:Me (Me=W, Ti...) | 400-600 °C |
| a-C:H:Me (Me=W, Ti...) | 350-500 °C |

Hierbei ist es bekannt, dass die thermische Stabilität und die Haftung von DLC Schichtsystemen grundsätzlich durch einen hohen sp3-Anteil, ein hohes E-Modul sowie eine ausreichend dicke Haftschicht insgesamt gewährleistet werden kann.

Die thermische Stabilität kann ferner durch Dotierung [Wu, W. -J., Hon, M. -H. (1999). Surf. Coat. Technol. 111: 134-140.], durch die Kristallstruktur [Zhang, S., Bui, X. L., Li, X. (2006). Diamond and Related Materials 15: 972-976.] oder durch den Herstellprozess [Jung, H. -S., Park, H. -H., Pang, S. S., Lee, S. Y. (1999) Thin Solid Films 355-356: 151-156.] verbessert werden. Ebenso sind die atmosphärischen Umgebungsbedingungen relevant [Ronkainen, H., Likonen, J., Koskinen, J., Varjus, S. (1996). Surf. Coat. Technol. 79: 87-94.].

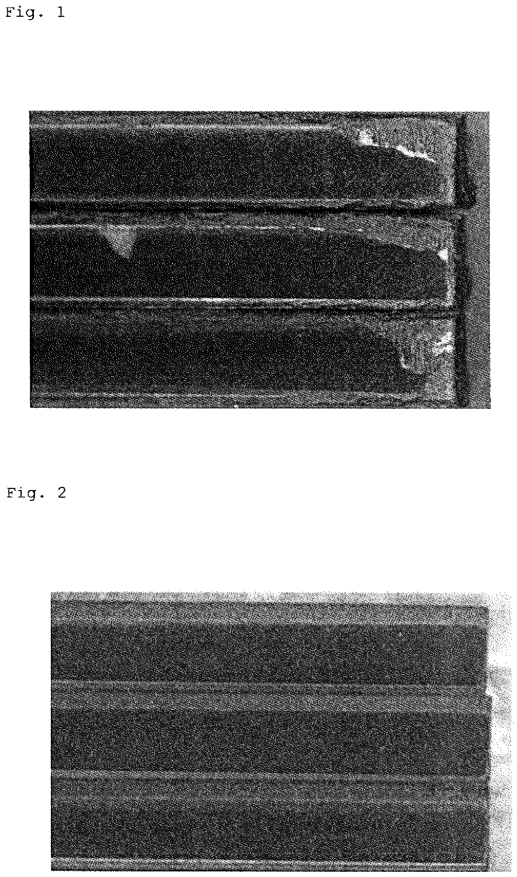

In ersten befeuerten motorischen Tests haben die Erfinder ermittelt, dass sich ta-C Beschichtungen in Dieselapplikationen auf Kompressionsringen im Bereich des Stoßes nach bereits 100h Laufzeit ablösen und damit die Funktionsfähigkeit des Kolbenrings hinsichtlich seines Abdichtverhaltens, aber auch der Bauteillebensdauer gefährdet ist (siehe Fig. 1). Aus Simulationen wurde berechnet, dass Temperaturen in der ersten Nut bei Dieselkolben von teilweise über 330 °C erreicht werden. Diese Temperaturen sind demnach bereits als kritisch zu sehen, obwohl diese weit unter den in der Literatur angegebenen Maximalwerten für die thermische Beständigkeit von ta-C Schichten (bis zu 500°C nach VDI Richtlinie 2840) liegen.

### Darstellung der Erfindung

Der Erfindung liegt daher die Aufgabe zugrunde, ein insbesondere im Hinblick auf die thermische und/oder thermochemische Haftung der Beschichtung verbessertes Gleitelement, insbesondere einen Kolbenring mit dieser Eigenschaft zu schaffen. Insbesondere soll ein Schichtsystem auf Basis eines DLC Beschichtungstyps bereitgestellt werden, das die thermische Beständigkeit in motorischen Anwendungen so weit erhöht, dass die Schichten die erwähnten maximalen Motortemperaturen überstehen können und eine gleichbleibende Verschleißbeständigkeit besitzen.

Die Lösung dieser Aufgabe erfolgt durch das im Patentanspruch 1 beschriebene Gleitelement.

Demzufolge weist dieses eine Beschichtung auf, die von innen nach außen folgende Schichten aufweist: eine polykristalline, metallhaltige Haftschicht, eine Zwischenschicht, und zumindest eine amorphe Kohlenstoffschicht. Hierbei weist die Zwischenschicht von innen nach außen zumindest eine AxCy Schicht und eine kristallinhaltige bzw. kristall- oder auch kristallithaltige Kohlenstoffschicht auf, wobei C für Kohlenstoff steht, A für ein Metall steht, vorzugsweise aus der metallhaltigen Haftschicht, und x sowie y jeweils Werte von 1-99 umfasst. Der Schichttyp der amorphen Kohlenstoffschichten kann dabei aus den in der VDI Richtlinie 2840 aufgeführten Typen ausgewählt werden.

Die Erfindung beruht auf der Erkenntnis, dass die Haftschicht polykristallin ist, während die äußere Schicht, die aufgrund ihrer Funktion, dauerhaft einen geringen Reibungskoeffizienten zu gewährleisten, als Funktionsschicht bezeichnet wird, amorph ist. Um hier einen vorteilhaften Übergang und eine gute Haftung sämtlicher Schichten zu gewährleisten, wird auf der Haftschicht zunächst die Zwischenschicht vorgesehen. Letztere weist eine vergleichsweise dünne, kompakte und gerichtete, teiltexturierte, kristallhaltige Struktur auf, so dass die Stabilität gewährleistet wird, und grundsätzlich mögliche Diffusionsprozesse innerhalb dieser Schicht sowohl in Richtung der Haft- als auch in Richtung der Funktionsschicht verhindert werden. Mit dem beschriebenen Schichtaufbau konnte in ersten Experimenten eine verbesserte thermische Beständigkeit und Haftung festgestellt werden. Die Beschichtung erfolgt bevorzugt mittels der sogenannten PVD-Arc-Technologie.

Figur 2 zeigt eine Aufnahme eines erfindungsgemäßen Beschichtungsaufbaus und verdeutlicht, dass selbst nach 300h Motorlauflaufzeit in demselben Motor, wie in Figur 1 beschrieben, die thermische Stabilität des im Patentanspruch 1 beschriebenen Gleitelements gegeben ist.

Bevorzugte Weiterbildungen des erfindungsgemäßen Gleitelements sind in den weiteren Ansprüchen beschrieben.

Bevorzugt weist das Gleitelement zwischen der AxCy Schicht und der kristallinhaltigen bzw. kristallhaltigen Kohlenstoffschicht eine Übergangsschicht auf, die sich aus einer Mischphase der AxCy Schicht und der kristallinhaltigen bzw. kristallhaltigen Kohlenstoffschicht konstituiert. Ein derartiger Schichtaufbau führt zu einer verbesserten Haftung zwischen den Teilschichten.

Für das Metall A der AxCy Schicht, bevorzugt auch der Haftschicht, werden z.B. Titan, Wolfram, jegliche Übergangsmetalle sowie besonders bevorzugt Chrom vorgesehen.

Gute Ergebnisse werden darüber hinaus für Nitride, und Carbonitride der genannten Metalle in der Haftschicht erwartet.

Für die Haftschicht hat sich darüber hinaus herausgestellt, dass diese eine Dicke von mehr als 80 nm aufweisen sollte, um auftretende mechanisch und/oder thermisch verursachte Querkräfte während der Anwendung ausreichend auszugleichen, also des Gleitelements, insbesondere des Kolbenring-Grundmaterials zu erreichen.

Für die AxCy-Schicht wird derzeit eine Dicke von 3 nm bis 10 nm, bevorzugt 4 nm bis 8 nm bevorzugt.

Für die kristallinhaltige bzw. kristallhaltige Kohlenstoffschicht hat sich herausgestellt, dass eine Dicke von ≤ 35 nm vorteilhaft ist.

Die Übergangsschicht ist bevorzugt 1 - 25 nm dick, um die beschriebenen vorteilhaften Effekte zu erreichen.

Für zumindest eine amorphe Kohlenstoffschicht wird bevorzugt, dass sie wasserstofffrei und/oder undotiert ist (nach VDI Richtlinie 2840 bedeutet dies, dass der Wasserstoffanteil ≤ 3At% beträgt), da derartige Schichten einen höheren Verschleißwiderstand und geringeren Reibungskoeffizienten, insbesondere bei der Anwendung in Verbrennungsmotoren, aufweisen.

Besonders bevorzugt werden zumindest zwei amorphe Kohlenstoffschichten vorgesehen, wobei weiter bevorzugt eine innere amorphe Kohlenstoffschicht ein höheres mittleres E-Modul aufweist als eine äußere amorphe Kohlenstoffschicht. Innerhalb der äußeren Kohlenstoffschicht kann dabei eine kontinuierliche Reduzierung des E-Modul vorliegen, um die Eigenspannungen innerhalb der gesamten C-Schicht zu harmonisieren.

Insbesondere bei einem System mit zwei amorphen Kohlenstoffschichten hat sich für die innere Schicht ein mittleres E-Modul von E₁ > 300 GPa als günstig erwiesen, da hierdurch die oben beschriebene Kompaktheit gewährleistet werden kann.

Für eine äußere amorphe Kohlenstoffschicht wird derzeit ein mittleres E-Modul E₂ bevorzugt, wobei E₂ < E₁ ist. Dadurch können auftretende Scherkräfte elastisch aufgenommen und zum Beispiel ein verbessertes Einlaufverhalten erreicht werden. Des Weiteren kann das E-Modul der äußeren amorphen Kohlenstoffschicht von innen nach außen abnehmen.

Für eine innere amorphe Kohlenstoffschicht, mit anderen Worten bevorzugt eine amorphe Kohlenstoffschicht mit vergleichsweise hohem E-Modul wird derzeit bevorzugt, dass ihre Dicke 5 % bis 30 % der Gesamtschichtdicke beträgt.

Für die Gesamtschichtdicke hat sich ferner 1 µm bis 50 µm als günstig erwiesen.

### Kurzbeschreibung der Figuren

Fig. 1 zeigt die Laufflächenbeschädigungen von konventionellen ta-C beschichteten Kolbenringen am Stoß nach einem 100h Hochleistungsmotorlauf im Dieselmotor.
Fig. 2 zeigt eine Stoßaufnahme von erfindungsgemäßen ta-C beschichteten Kolbenringen am Stoß nach 300h Motorlauf im Dieselmotor.

### Bevorzugte Ausführungsform

Besonders bevorzugt wird derzeit ein Schichtaufbau von innen nach außen mit einer Haftschicht aus Chrom, einer Zwischenschicht (bestehend aus einer CrxCy Schicht, einer Mischphasen-Übergangsschicht aus CrxCy Schicht und kristallinhaltiger bzw. kristallhaltiger Kohlenstoffschicht und einer kristallinhaltigen bzw. kristallhaltigen Kohlenstoffschicht), und zwei wasserstofffreien amorphen Kohlenstoffschichten, wobei die Teilschichten die in den Ansprüchen 5-8 definierten Schichtdicken aufweisen.

Insbesondere verglichen mit einer dünneren Haftschicht und einer dickeren kristallinhaltigen bzw. kristallhaltigen Kohlenstoffschicht konnte für den bevorzugten Aufbau eine um bis zu 50°C höhere thermische Stabilität in sauerstoffhaltiger Atmosphäre festgestellt werden. Konkret hatte die Haftschicht des Vergleichsbeispiels eine Dicke von < 80 nm, und die kristallinhaltige bzw. kristallhaltige Kohlenstoffschicht eine Dicke von 40 nm bis 60 nm.

Als Herstellprozess ist dabei in vorteilhafterweise ein PVD-Arc-Verfahren zu verwenden.

Beispielsweise können die C-Ionen mit hoher Energie in die Haftschicht eindringen, um eine CrxCy Schicht zu erzeugen, die nur wenige Nanometer dick ist. Energetisch bedingt dringen die C-Ionen nicht nur in die Schicht ein, sondern es besteht ebenfalls die Möglichkeit, dass Ionen wieder zur Oberfläche diffundieren und sich dadurch eine erste kristallinhaltige bzw. kristallhaltige Kohlenstoffschicht bildet. Dieser Effekt wird als Subplantation bezeichnet und ausführlich in dem Paper von J. Robertson beschrieben (J. Robertson, Diamond-like amorphous carbon; Material Science and Engineering R37; 2002; 129-281).

Diese Schicht, die sich mittels hochenergetischen C-Ionen einstellt, wird in diesem Text als kristallinhaltige bzw. kristall- oder auch kristallithaltige Kohlenstoffschicht bezeichnet. Die Schicht kann teilkristallin (nc-Graphit, d.h. einzelne ungeordnet orientierte Cluster haben sich gebildet) oder kristallin (orientierte Clusterebenen) sein, wobei die Kohlenstoffatome überwiegend sp2-hybridisiert sind. Dabei beträgt die maximale Verbreitung bzw. Erstreckung der Clusterebenen von einer CrxCy Schicht ca. 100 nm. Der Abstand zwischen den Clusterebenen kann sehr klein sein bis zur Atomlage. Ferner sind die in der Schicht enthaltenen kristallinen C-Phasen nanoskalig. Was sich durch die Prozessparameter einstellt, kann mittels der sogenannten Raman Spektroskopie nach A.C. Ferrari und J. Robertson nachgewiesen werden (Physical Review B; Vol 61; Number 20; 2000; 14095-14107). Elektronenmikroskopische Untersuchungen der erfindungsgemäßen Beschichtung, insbesondere der Zwischenschicht, beispielsweise mittels TEM und SAED ("Selected Area Electron Diffraction") zeigen u.a. teilelliptische Reflexe im Beugungsbild, die Graphen-Reflexen entsprechen. Daraus lässt sich das Vorliegen von kristallinem Kohlenstoff in der Kohlenstoffschicht der Zwischenschicht und eine Teilkristallinität dieser ableiten. In TEM-Hellfeldaufnahmen der Zwischenschicht sind sowohl diskrete Kreise, die auf das kubisch raumzentrierte Kristallgitter von Cr hindeuten, als auch elliptische Graphen-Reflexe zu erkennen. Daraus ergibt sich ferner die Koexistenz von kristallinen Cr-Phasen und kristallinen C-Phasen in der Zwischen- bzw. der Übergangsschicht der Beschichtung des erfindungsgemäßen Gleitelements.

Es hat sich herausgestellt, dass in dem nachfolgenden Prozess, in dem durch eine Abscheidung von C-Ionen mit niedrigerer Energie die amorphe Kohlenstoffschicht hergestellt wird, eine hervorragende Haftung gewährleistet werden kann, wenn die erfindungsgemäße Zwischenschicht zwischen Haftschicht und amorpher Kohlenstoffschicht bereitgestellt wird. Insbesondere wenn die kristallinhaltige bzw. kristallhaltige Kohlenstoffschicht zu dick ist, können Querkräfte nicht mehr aufgenommen werden, da die Kristallebenen der kristallinhaltigen bzw. kristallhaltigen Kohlenstoffschicht in einem bevorzugten Winkel zur Oberfläche wachsen. Dann kommt es zu einer Ablösung der amorphen C-Funktionsschicht von der kristallinhaltigen bzw. kristallhaltigen Kohlenstoffschicht. Querkräfte können durch eine äußere mechanische Kraft entstehen, z.B. durch eine Auf- und Abwärtsbewegung eines Kolbenrings in dem Zylinder eines Verbrennungsmotors verbunden mit einem Misch- oder Grenzreibungszustand, oder durch eine thermische Energie, was zu Verspannungen im Übergang Fe-basiertes Substrat zur Kohlenstoffschicht durch stark unterschiedliche thermische Ausdehnungskoeffizient führt.

Bei Experimenten zu den hier erwähnten Schichten wurde eine Vermischung von Cr und C zu CrxCy sowie CrxCy und der kristallinhaltigen bzw. kristallhaltigen Kohlenstoffschicht durch eine starke Beschleunigung der C-Ionen erreicht. Die Beschleunigung ist mittels einer hohen sogenannten BIAS Spannung gegeben, die direkt am Bauteil eingestellt wird. Zu hohe Temperaturen bewirken die Entstehung von C-Clustern, überwiegend mit sp2-Bindungen, bevorzugt anisotrop verteilt, wodurch die Stabilität des Übergangs reduziert wird. Bei Temperaturen < 120°C kommt es zu einer mehr isotropen Ausbildung von sp2-reichen Kristallebenen, dem sogenannten nc-Graphit. Diese besitzen eine höhere thermische und mechanische Stabilität.

Für die Zwischenschicht sind daher bevorzugt Temperaturen 30 - 120°C und BIAS-Spannungen von 500 - 1200V einzuhalten, während für die DLC-Funktionsschichten bevorzugt Temperaturen von < 250°C und BIAS-Spannungen 10 - 200V einzustellen sind. Wie dem Fachmann bekannt ist, lassen sich durch Einstellung der Spannung und Temperatur im genannten Parameterbereich insbesondere auch die erfindungsgemäßen E-Modul-Verläufe einstellen.

Alle für das obige Cr-basierte Ausführungsbeispiel gemachten Aussagen zur Beschaffenheit und (Nano-) Struktur insbesondere der Zwischen- und Übergangsschicht treffen für alle von der vorliegenden Erfindung umfassten Beschichtungen zu.

## Patentansprüche

1. Gleitelement, insbesondere Kolbenring, mit einer Beschichtung, die von innen nach außen folgende Schichten aufweist:
- eine polykristalline, metallhaltige Haftschicht,
- eine Zwischenschicht, und
- zumindest eine amorphe Kohlenstoffschicht,
wobei die Zwischenschicht von innen nach außen zumindest die folgenden Teilschichten aufweist:
- eine AxCy Schicht, wobei C für Kohlenstoff steht, A für ein Metall, vorzugsweise aus der metallhaltigen Haftschicht, steht, und x sowie y jeweils Werte von 1-99 umfasst, und
- eine kristallinhaltige Kohlenstoffschicht, wobei die Kohlenstoffatome überwiegend sp²-hybridisiert sind.

2. Gleitelement nach Anspruch 1,
**dadurch gekennzeichnet, dass**
das Gleitelement zwischen der AxCy Schicht und der kristallinhaltigen Kohlenstoffschicht eine Übergangsschicht aufweist, die sich aus einer Mischphase der AxCy Schicht und der kristallinhaltigen Kohlenstoffschicht konstituiert.

3. Gleitelement nach Anspruch 1 oder 2,
**dadurch gekennzeichnet, dass**
das Metall A aus Wolfram, Titan, Chrom oder einem weiteren Übergangsmetall ausgewählt ist.

4. Gleitelement nach einem der vorangehenden Ansprüche,
**dadurch gekennzeichnet, dass**
die Haftschicht ein Nitrid oder Carbonitrid eines Metalls enthält und/oder, dass
die Haftschicht eine Dicke von mehr als 80 nm aufweist.

5. Gleitelement nach einem der vorangehenden Ansprüche,
**dadurch gekennzeichnet, dass**
die AxCy Schicht eine Dicke von 3 nm bis 10 nm, bevorzugt 4 nm bis 8 nm aufweist.

6. Gleitelement nach einem der vorangehenden Ansprüche,
**dadurch gekennzeichnet, dass**
die kristallinhaltige Kohlenstoffschicht eine Dicke von nicht mehr als 35 nm aufweist.

7. Gleitelement nach einem der Ansprüche 2 bis 6,
**dadurch gekennzeichnet, dass**
die Übergangsschicht eine Dicke von 1 bis 25 nm aufweist.

8. Gleitelement nach einem der vorangehenden Ansprüche,
**dadurch gekennzeichnet, dass**
zumindest eine amorphe Kohlenstoffschicht wasserstofffrei und/oder undotiert ist.

9. Gleitelement nach einem der vorangehenden Ansprüche,
**dadurch gekennzeichnet, dass**
zumindest zwei amorphe Kohlenstoffschichten vorgesehen sind.

10. Gleitelement nach einem der vorangehenden Ansprüche,
**dadurch gekennzeichnet, dass**
eine innere amorphe Kohlenstoffschicht ein höheres E Modul aufweist als eine äußere amorphe Kohlenstoffschicht.

11. Gleitelement nach Anspruch 9 oder 10,
**dadurch gekennzeichnet, dass**
eine innere amorphe Kohlenstoffschicht ein mittleres E Modul von mehr als 300 GPa aufweist.

12. Gleitelement nach einem der Ansprüche 9 bis 11,
**dadurch gekennzeichnet, dass**
eine äußere amorphe Kohlenstoffschicht ein mittleres E Modul aufweist, das geringer ist als das E-Modul der inneren amorphen Kohlenstoffschicht und/oder, dass
das E-Modul der äußeren amorphen Kohlenstoffschicht ausgehend von der inneren Kohlenstoffschicht in Richtung Oberfläche abnimmt.

13. Gleitelement nach einem der Ansprüche 9 bis 12,
**dadurch gekennzeichnet, dass**
eine innere amorphe Kohlenstoffschicht 5 % bis 30 % der Gesamtschichtdicke ausmacht.

14. Gleitelement nach einem der vorangehenden Ansprüche,
**dadurch gekennzeichnet, dass**
die Gesamtschichtdicke 1 µm bis 50 µm beträgt.

15. Gleitelement nach einem der vorangehenden Ansprüche,
**dadurch gekennzeichnet, dass**
die Schicht mit einem PVD Verfahren hergestellt ist.

## Claims

1. Sliding element, in particular a piston ring, having a coating which has the following layers from the inside outwards:
- a polycrystalline, metal-containing adhesive layer,
- an intermediate layer, and
- at least one amorphous carbon layer,
the intermediate layer having at least the following partial layers from the inside outwards:
- an AxCy layer, C standing for carbon, A standing for a metal, preferably of the metal-containing adhesive layer, and x as well as y each comprising values of 1-99, and
- a crystalline-containing carbon layer, wherein the carbon atoms are predominantly sp²-hybridized.

2. Sliding element according to claim 1,
**characterized in that**
the sliding element between the AxCy layer and the crystalline-containing carbon layer has a transition layer which is constituted by a mixed phase of the AxCy layer and the crystalline-containing carbon layer.

3. Sliding element according to claim 1 or 2,
**characterized in that**
the metal A is chosen from tungsten, titanium, chromium or a further transition metal.

4. Sliding element according to one of the preceding claims,
**characterized in that**
the adhesive layer contains a nitride or carbonitride of a metal and/or, that
the adhesive layer has a thickness of more than 80 nm.

5. Sliding element according to one of the preceding claims,
**characterized in that**
the AxCy layer has a thickness of 3 nm to 10 nm, preferably 4 nm to 8 nm.

6. Sliding element according to one of the preceding claims,
**characterized in that**
the crystalline-containing carbon layer has a thickness of no more than 35 nm.

7. Sliding element according to one of claims 2 to 6,
**characterized in that**
the transition layer has a thickness of 1 to 25 nm.

8. Sliding element according to one of the preceding claims,
**characterized in that**
at least one amorphous carbon layer is hydrogen-free and/or undoped.

9. Sliding element according to one of the preceding claims,
**characterized in that**
at least two amorphous carbon layers are provided.

10. Sliding element according to one of the preceding claims,
**characterized in that**
an inner amorphous carbon layer has a higher e-modulus than an outer amorphous carbon layer.

11. Sliding element according to claim 9 or 10,
**characterized in that**
an inner amorphous carbon layer has an average e-modulus of more than 300 GPa.

12. Sliding element according to one of claims 9 to 11,
**characterized in that**
an outer amorphous carbon layer has an average e-modulus that is smaller than the e-modulus of the inner amorphous carbon layer and/or, that
the e-modulus of the outer amorphous carbon layer decreases starting from the inner carbon layer in the direction of the surface.

13. Sliding element according to one of claims 9 to 12,
**characterized in that**
an inner amorphous carbon layer makes up 5% to 30% of the total thickness.

14. Sliding element according to one of the preceding claims,
**characterized in that**
the total thickness is 1 µm to 50 µm.

15. Sliding element according to one of the preceding claims
**characterized in that**
the layer is produced with a PVD method.

## Revendications

1. Élément coulissant, notamment un segment de piston, comprenant un revêtement présentant de l'intérieur vers l'extérieur les couches suivantes :
- une couche adhésive métallique, polycristalline,
- une couche intermédiaire, et
- au moins une couche de carbone amorphe,
la couche intermédiaire présentant, de l'intérieur vers l'extérieur, au moins les couches partielles suivantes :
- une couche AxCy, C représentant du carbone, A représentant un métal, de préférence de la couche adhésive métallique, et x ainsi que y représentant respectivement des valeurs de 1 à 99, et
- une couche de carbone cristalline, les atomes de carbone étant principalement hybrides sp².

2. Élément coulissant selon la revendication 1, **caractérisé en ce que**
l'élément coulissant entre la couche AxCy et la couche de carbone cristalline présente une couche de transition qui est constituée d'une phase mixte de la couche AxCy et de la couche de carbone cristalline.

3. Élément coulissant selon la revendication 1 ou 2,
**caractérisé en ce que**
le métal A est choisi parmi du tungstène, du titane, du chrome ou un autre métal de transition.

4. Élément coulissant selon l'une quelconque des revendications précédentes, **caractérisé en ce que**
la couche adhésive contient un nitrure ou un carbonitrure d'un métal et/ou que
la couche adhésive a une épaisseur supérieure à 80 nm.

5. Élément coulissant selon l'une quelconque des revendications précédentes, car
actérisé en ce que
la couche AxCy a une épaisseur de 3 nm à 10 nm, de préférence de 4 nm à 8 nm.

6. Élément coulissant selon l'une quelconque des revendications précédentes, ca
ractérisé en ce que
la couche de carbone cristalline a une épaisseur non supérieure à 35 nm.

7. Élément coulissant selon l'une quelconque des revendications 2 à 6, **caractérisé en ce que**
la couche de transition a une épaisseur de 1 à 25 nm.

8. Élément coulissant selon l'une quelconque des revendications précédentes, ca
ractérisé en ce que
au moins une couche de carbone amorphe est exempte d'hydrogène et/ou non dopée.

9. Élément coulissant selon l'une quelconque des revendications précédentes, ca
ractérisé en ce que
au moins deux couches de carbone amorphe sont prévues.

10. Élément coulissant selon l'une quelconque des revendications précédentes, ca
ractérisé en ce que
une couche de carbone amorphe interne a un module d'élasticité plus élevé qu'une couche de carbone amorphe externe.

11. Élément coulissant selon la revendication 9 ou 10, **caractérisé en ce que**
une couche de carbone amorphe interne a un module d'élasticité moyen supérieur à 300 GPa.

12. Élément coulissant selon l'une quelconque des revendications 9 à 11, **caractérisé en ce que**
une couche de carbone amorphe externe a un module d'élasticité moyen inférieur au module d'élasticité de la couche de carbone amorphe interne et/ou que
le module d'élasticité de la couche de carbone amorphe externe diminue de la couche de carbone interne vers la surface.

13. Élément coulissant selon l'une quelconque des revendications 9 à 12, **caractérisé en ce que**
une couche de carbone amorphe interne représente 5 % à 30 % de l'épaisseur totale de la couche.

14. Élément coulissant selon l'une quelconque des revendications précédentes, car
actérisé en ce que
l'épaisseur totale de la couche est de 1 µm à 50 µm.

15. Élément coulissant selon l'une quelconque des revendications précédentes,
**caractérisé en ce que**
la couche est réalisée à l'aide d'un procédé PVD.
